Europäisches Patentamt

European Patent Office

Office européen des brevets

(11) Publication number: **0 132 322**
A2

# EUROPEAN PATENT APPLICATION

(21) Application number: **84304406.6**

(22) Date of filing: **28.06.84**

(51) Int. Cl.⁴: **C 23 C 14/06,** C 23 C 14/24

(30) Priority: **17.02.84 US 581139**
**29.06.83 US 509159**

(43) Date of publication of application: **30.01.85**
**Bulletin 85/5**

(84) Designated Contracting States: **AT BE CH DE FR GB IT**
**LI LU NL SE**

(71) Applicant: **STAUFFER CHEMICAL COMPANY, Westport**
**Connecticut 06881 (US)**

(72) Inventor: **Baumann, John Andrew, 112 Pine Avenue,**
**Ossining NY 10562 (US)**
Inventor: **Brock, David Geoffrey, 126 Forest Drive, Mt.**
**Kisco NY 10549 (US)**

(74) Representative: **Smith, Sydney et al, Elkington and Fife**
**High Holborn House 52/54 High Holborn, London**
**WC1V 6SH (GB)**

(54) Thermal crackers for forming pnictide films in high vacuum processes.

(57)    An apparatus for forming an evaporated pnictide-containing film on a substrate characterised in that it comprises a cracker adjacent to the substrate is disclosed.

A process for the production of an evaporated pnictide-containing film on a substrate characterised in that it comprises deposition thereof using a cracker is also disclosed.

Referring to the accompanying illustrative drawing, the present apparatus may comprise a cracker 34 adjacent to a substrate 28.

The present invention represents an advance over the prior art.

Thermal crackers for forming pnictide films in high vacuum processes

This invention relates to thermal crackers for forming pnictide films in high vacuum processes; more particularly, it relates to the production of such films in a vacuum evaporator utilizing separately heated sources for the elements to be deposited. Superheated tungsten crackers are employed at the phosphorus source and below the substrates to ensure that only the Pnictide$_2$ species, not the Pnictide$_4$ species, reaches the substrates. The products produced include a pure phosphorus semiconducting amorphous film having an optical band edge at 2.0 eV, insulating films for MIS devices on III-V semiconductors and catenated phosphorus semiconductors $MP_x$ wherein x ranges from 15 to infinity. The present invention also relates to the modification of such films by the incorporation of co-evaporated metal and to the production of electronic semiconductor devices, electro-optical devices, thin films, optical films and coatings. The present invention further relates to the employment of a thermal cracker in molecular beam epitaxy to convert Pnictide$_4$ to Pnictide$_2$. Fine quality, pure phosphorus films have been produced for passivation and insulation of III-V semiconductors and for other uses.

For further information, reference may be made, to for example, GB-A- 2,113,663 and to the related applications filed herewith, in particular those based on USSN 581,104, USSN 581,102, USSN 509,157, USSN 509,175, USSN 581,115, USSN 509,158, USSN 581,103, USSN 581,105 and USSN 581,101.

The above-identified related applications disclose semiconductors formed of catenated phosphorus materials. It is highly desirable that uniform thin films of these materials be formed on a variety of substrates for use in electronic and electro-optical devices, as optical films coatings, for example. It is further highly desirable that an easy and convenient method be found to reduce the intrinsic resistivity of these materials.

In particular, the above-identified related application based on USSN 581,115 relates to the insulation and passivation of III-V semiconductors and a new amorphous thin film form of phosphorus. Apparatus and methods for efficiently producing these films are highly desirable.

It is therefore an object of the present invention to provide high vacuum deposited film of catenated phosphorus material.

Another object of the present invention is to provide passivating and insulating films on III-V materials.

A further object of the present invention is to provide pure phosphorus thin films by high vacuum deposition.

A still further object of the present invention is to provide such films on a variety of substrates.

Yet another object of the present invention is to provide semiconductor and electro-optical devices, optical films and coatings.

A still further object of the present invention is to provide improved high vacuum deposition apparatus and methods using vacuum deposition and molecular beam epitaxy.

Yet another object of the present invention is to provide such apparatus and methods for the production of films of pnictides, particularly phosphorus.

The present invention provides an apparatus for forming an evaporated pnictide-containing film on a substrate characterised in that it comprises a cracker adjacent to the substrate.

Particularly in the case of deposition of an alkali metal polypnictide film, a heated alkali metal intercalate source may be used. It is generally a graphite intercalate, for example $KC_8$.

In one embodiment, the present apparatus may be a molecular beam apparatus comprising a pnictide beam collimator, a substrate holder and a heated filament therebetween.

The present invention also provides a process for the production of an evaporated pnictide-containing film on a substrate characterised in that it comprises deposition thereof using a cracker.

The cracker is generally heated and may be a heated filament.

Preferably, the film comprises $MP_x$ wherein M represents an alkali metal and x is substantially equal to or greater than 15, for example $KP_{15}$.

Preferably, the pnictide consists essentially of phosphorus and the cracker is heated to above 1000°C.

The pnictide may be formed into a collimated molecular beam before deposition. The substrate may be glass, metallized glass or a III-V semiconductor, such as gallium phosphide and/or gallium arsenide.

For a fuller understanding of the nature and objects of the present invention reference may be made to the accompanying illustrative drawings wherein:

Figure 1 is a schematic diagram of vacuum evaporation apparatus according to the present invention;

Figure 2 is a schematic plan view of molecular beam apparatus according to the present invention; and

Figure 3 is a partial schematic cross-sectional view taken along the line 3-3 of Figure 2.

The same reference numbers refer to the same elements throughout the several views of the drawings.

High quality thin films of polyphosphides, for example $KP_{15}$ and $KP_x$, wherein x is greater than 15, have been produced by a novel vacuum co-evaporation process. This process has produced fine quality films having surface irregularities no greater than approximately 20 Angstroms ($2 \times 10^{-7}$ cms). It offers the ability easily to change the stoichiometery of the depositing film at any point during a deposition.

The process also provides the ability to form pure phosphorus amorphous films which may be especially useful to insulate and passivate III-V semiconductors.

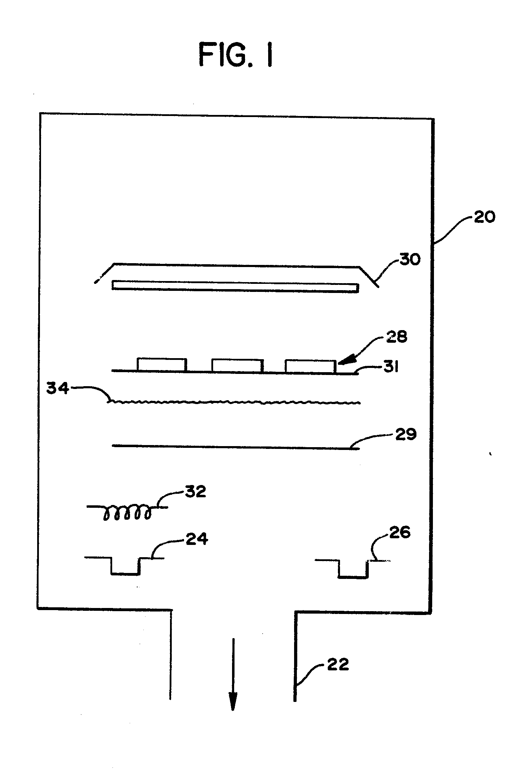

The vacuum evaporations may be performed in a Cooke high vacuum evaporator model CVE-301. This apparatus has a 12" (30 cm) stainless steel bell jar and a diffusion pump system with a base pressure of less than $10^{-6}$ Torr ($1.33 \times 10^{-4}$ Pa). The system schematic is illustrated in the accompanying drawing (Figure 1). The bell jar 20 is pumped through outlet 22. Substrates 28, which have included glass, silicon, gallium phosphide, gallium arsenide and indium phosphide, are radiantly heated to temperatures between 25 and 325°C and exposed to the upwardly directed vapour streams through openings in support 31 (not shown). Baffled sources 24 and 26 (obtained from R.D. Mathis) are used for the phosphorus and the potassium, respectively. They are resistively heated, boats made from molybdenum or tantalum. The potassium source may be elemental potassium or preferably a graphite intercalate, such as $KC_8$, as disclosed in the above-mentioned related application based on USSN 509,157, the phosphorus is cracked from $P_4$ to $P_2$ by two high temperature tungsten filaments heated to greater than 1000°C. The first 32 is located in the vapour stream emerging from the source 24 and the other 34 is located just below the substrates 28. The use of the cracker 34 at the substrates 28 is critical in that it prevents the reformation of $P_4$ molecules which reduces the efficiency of the process.

The phosphorus source which contains red phosphorus is resistively heated to from 300 to 700°C and the potassium source is heated to from 100 to 400°C by high current power supplies. By changing the source temperatures, the evaporation rates may be controlled to produce KP compounds of different stoichiometries.

Further evaporation sources may be added to provide dopants, for example an independently heated and controlled source of the $Al_2O_3$ crucible type heated by a tantalum wire basket may be utilized to evaporate nickel wire, heated to a temperature just below its melting point. This system has been used to provide nickel doped $KP_{15}$ films.

The single phosphorus boat has been utilized to provide amorphous red pure phosphorus films.

Films of phosphorus and polyphosphides have been

0132322

-6-

provided on gallium phosphide, gallium arsenide, indium phosphide, glass and metallized glass substrates, metallized with nickel and titanium.

The present process employing the cracker 34 just below the substrates 28 may be utilized with other phosphorus sources than the heated baffle boat 24. For example, phosphine could be admitted to the system which would be reacted at the cracker 34 to provide the $P_2$ species employed. This would be the best way to utilize phosphine as a phosphorus source, however, phosphine could also be introduced without the use of the cracker 34 to react with the potassium at the substrates 28 and glow discharge could be employed to activate this reactive evaporation.

A thermal cracker according to the present invention has been employed in molecular beam epitaxy between the exit end of the baffle or collimator and the substrates and have produced fine quality films of polyphosphides and of a new amorphous form of phosphorus having a layer-like, puckered sheet-like structure.

Vacuum Evaporation

Example 1

Referring to accompanying Figure 1, a Cooke high vacuum evaporator 20 Model CVE 301, was diffusion pumped through outlet 22 to a base pressure of less than $1 \times 10^{-6}$ Torr ($1.33 \times 10^{-4}$ Pa). Two baffle boat sources for coevaporation obtained from R. D. Mathis were used, one 24 containing powdered red phosphorus, the other 26 containing granular $KC_8$, a graphite intercalation compound. The sources were independently, resistively heated and the temperature monitored by thermocouples. The substrates 28 were approximately 6" (15 cms) above the sources and shielded by a movable shutter 29. A quartz radiant heater 30 was used to bring the substrate temperature to 275 - 285°C. The substrates were glass, metallized glass (metallized with Ni and Ti), GaP, GaAs and InP.

Two high temperature tungsten "crackers" were used to convert the evaporating $P_4$ species to $P_2$. One is a coiled filament 32 directly above the exit of the P source; the other was a straight wire 34 1" (2.5 cms) below the substrates. Both wires are resistively heated to above 1000°C.

The phosphorus source 24 is heated until a constant pressure of from 8 to $9 \times 10^{-4}$ Torr (from 10.64 to $11.97 \times 10^{-2}$ Pa) is reached, as measured by a vacuum ionization gauge in the chamber 20. The $KC_8$ source 26 is heated to 275 - 295°C. When both the $KC_8$ temperature and chamber pressure are stabilized, the shutter 29 is moved to allow deposition of the film. A 3 hour deposition under these conditions will deposit approximately 1 micron (μm) of $KP_{15}$ as determined by X-ray fluorescence and Raman spectroscopy.

Example 2

This relates to an identical experimental apparatus and procedure as was used in Example 1 with the addition of a third evaporation source. This, independently heated and controlled source is of the $Al_2O_3$ crucible type heated by a Ta wire basket. The evaporant material was Ni wire which was maintained at a temperature just below its melting point of 1453°C. A 2 hour deposition yields from 1.3 to 1.6 micron (μm) films of 0.2% Ni doped $KP_{15}$ films as determined by X-ray fluorescence, Raman spectroscopy and ESCA.

Example 3

This relates to an identical experimental apparatus and procedure as Example 1, but with a substrate temperature of 275 - 300°C, a $KC_8$ source temperature of 255 - 275°C and a chamber pressure of $1 \times 10^{-3}$ Torr (1.33 x

0132322

-8-

$10^{-1}$ Pa). The films resulting from a 3 hour deposition are extremely smooth and shiny. The film thickness is from 1.5 to 2.0 microns ($\mu$m) and the composition ranges from $KP_{40}$ to greater than $KP_{100}$. Thus, stoichiometry may be controlled by the relative evaporation rates of the sources and thus by the temperatures of the sources.

Example 4

This relates to an identical experimental apparatus and procedure as in Example 1, but without a $KC_8$ source. A 2 hour deposition at a pressure of $9\times10^{-4}$ Torr (11.97 x $10^{-2}$ Pa) and with a 285°C substrate temperature, yielded smooth, shiny red films from 0.5 to 1.5 microns ($\mu$m) thick with an optical band edge at 2.0 eV. These films are amorphous by Raman spectroscopy. These films have been deposited on glass, metallized glass (Ni and Ti), GaP, GaAs and InP. They have a high resistivity of greater than $10^{10}$ (ohm-cm) and a breakdown voltage in the order of $10^5$ volts per centimetre. They may therefore be used as the insulating or passivating layers in devices formed on III-V semiconductors as disclosed in the above-identified related application based on USSN 581,115.

The graphite intercalation compounds used as a source of potassium in Examples 1 and 2 are disclosed in the related application based on USSN 509,157 to which reference may be made.

Molecular Beam Epitaxy

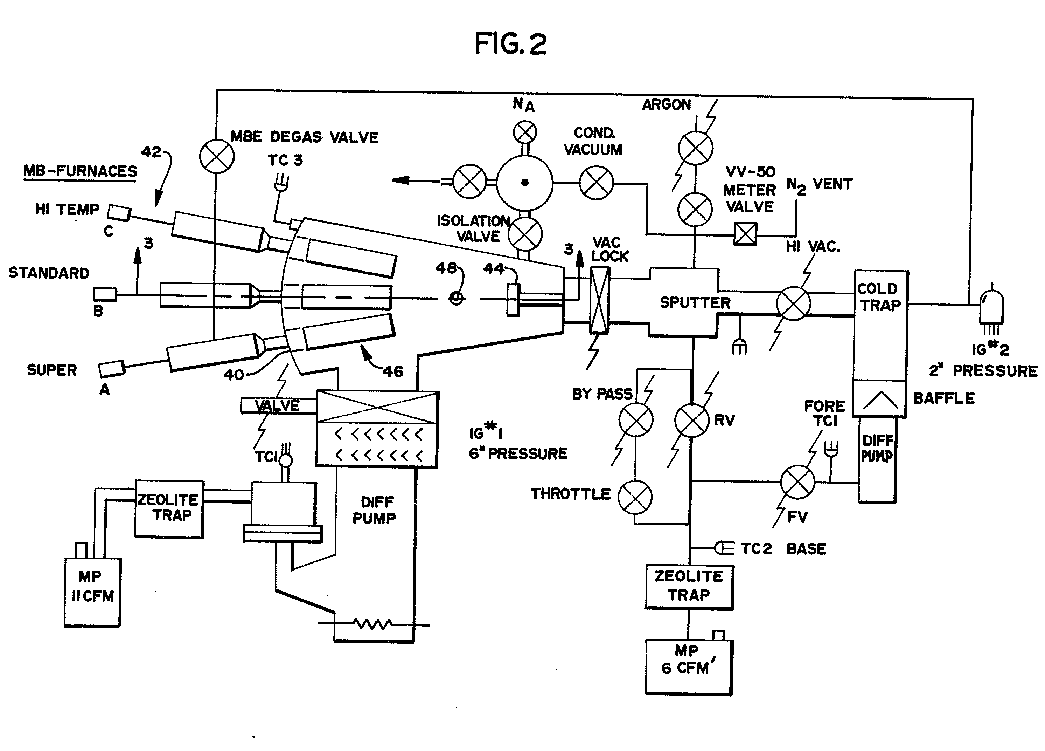

Molecular beam apparatus employing the thermal cracker according to the present invention is illustrated schematically in accompanying Figure 2. The system illustrated is a Vactronics, Inc. molecular beam epitaxy system Model 6000S. It comprises a vacuum chamber 40, molecular beam furnaces generally indicated at 42, a target support 44, molecular beam water-cooled baffles or collimators 46 and an electrically heated filament 48 which acts as the thermal cracker. Various vacuum systems are illustrated schematically connected to the vacuum chamber 40.

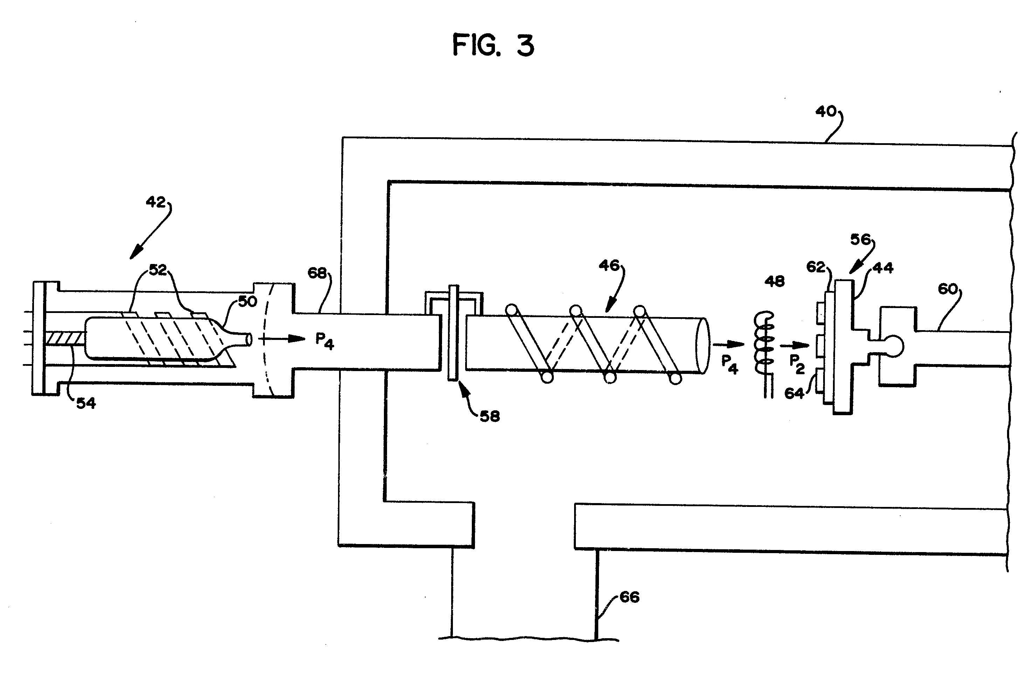

More specifically, referring to accompanying Figure 3, a molecular beam furnace that comprises a Knudsen cell 50 is electrically heated by a resistance heater 52. The Knudsen cell is contacted by a thermocouple 54 so that the temperature may be controlled. For depositing phosphorus, the Knudsen cell 50 contains red phosphorus and the phosphorus exits the Knudsen cell as shown by the arrow as $P_4$ species. Those molecules which are not directed at the target, generally indicated at 56, condense on the wall of the water-cooled baffle generally indicated at 46. The beam may be turned on and off by means of a shutter, generally indicated at 58. The $P_4$ species exiting the collimator 46 is cracked by the heated filament 48 to $P_2$ species which proceeds to the target 56.

The target comprises target holder 44 and support 60. The target may comprise, for example, a glass substrate 62 with III-V crystals 64 mounted thereon. The entire apparatus is drawn to high vacuum through the exit port 66.

Preparation of Insulating Films of Amorphous Phosphorus by Molecular Beam Epitaxy

The Vactronics, Inc. molecular beam epitaxy system, Model 6000S illustrated in accompanying Figure 3, was diffussion pumped to a base pressure less than 5 x $10^{-7}$ Torr (6.65 x $10^{-5}$ Pa). A resistively-heated Knudsen cell gun 42 mounted on a CON-FLAT port 68 on the vacuum chamber was axially aligned with a target substrate holder. The gun port was about 55 cm from the substrate holder. A water-cooled cylindrical baffle 46 about 30 cm long was used to help collimate the evaporant beam from the gun. A shutter 58 was positioned between the port and the baffle. Substrates 64 were InP or GaAs crystals mounted on a Corning 7059 glass plate 62 with silver paint. The molecular beam epitaxy gun 42, which was initially loaded with about 40 grams of red phosphorus (99.9999% purity), was taken to about 200°C. A pressure of $1 \times 10^{-5}$ Torr ($1.33 \times 10^{-3}$ Pa) was measured by an ionization gauge located at the top of the pumping stack.

A coiled filament 48 mounted between the baffle 46 exit and the substrates 64 (about 20cm from the latter) was resistively heated to temperatures above 1000°C.

The heated filament 48 is used to thermally crack the $P_4$ evaporant species to $P_2$. A deposition time of 100 minutes, terminated by shutting off the filament 48, resulting in a 400Å ($4 \times 10^{-6}$ cms) thick film.

Several of these phosphorus films, ranging in thickness from 400 to 2500Å (from $4 \times 10^{-6}$ to $2.5 \times 10^{-5}$ cms) and deposited at rates of from 4 to 26Å/min (from $4 \times 10^{-8}$ to $2.6 \times 10^{-7}$ cms/min) were evaluated for intrinsic electro-optical properties. The performance thereof in MIS device configurations were equal to or better than those observed earlier for the films prepared by vacuum evaporation.

From the electrical characterization, the density of surface states at the phosphorus - InP interface has been estimated to be about $10^{-10} cm^{-2} eV^{-1}$.

While the present invention has been exemplified with reference to the use of phosphorus it is contemplated that other pnictides, such as arsenic, antimony and bismuth, or combinations thereof, may also be deposited or co-deposited as films using these same techniques.

While there has been disclosed using red phosphorus heated in a furance or boat as the source of $Pnictide_4$ species, a controlled leak of $Pnictide_4$ carried by an inert gas supplied by a pnictide bubbler may also be employed to provide for better control and continuous operation. For disclosure of such apparatus reference may be made to the above-identified related applications based on USSN 581,102 and USSN 581,104.

-12-

## CLAIMS

1.    An apparatus for forming an evaporated pnictide-containing film on a substrate (28) characterised in that it comprises a cracker (34) adjacent to the substrate.

2.    An apparatus as claimed in claim 1 wherein the cracker is heated.

3.    An apparatus as claimed in claim 1 or claim 2 wherein the cracker is a heated filament.

4.    An apparatus as claimed in any of claims 1 to 3 characterised in that it comprises a heated alkali metal intercalate source.

5.    An apparatus as claimed in any of claims 1 to 4 characterised in that it is a molecular beam apparatus comprising a pnictide beam collimator (46), a substrate holder (44) and a heated filament (48) therebetween.

6.    A process for the production of an evaporated pnictide-containing film on a substrate characterised in that it comprises deposition thereof using a cracker.

7.    A process as claimed in claim 6 wherein the cracker is heated.

8.    A process as claimed in claim 7 wherein the cracker is heated to above 1000°C.

9.    A process as claimed in any of claims 6 to 8 wherein a heated alkali metal intercalate source is used.

10.    A process as claimed in claim 9 wherein a graphite intercalate is used.

11. A process as claimed in claim 9 or claim 10 wherein $KC_8$ is used.

12. A process as claimed in any of claims 6 to 11 wherein the pnictide is formed into a collimated molecular beam before deposition.

13. A process as claimed in any of claims 6 to 12 wherein the pnictide consists essentially of phosphorus.

14. A process as claimed in any of claims 6 to 13 wherein the substrate is selected from glass, metallized glass and III-V semiconductors.

15. A process as claimed in claim 14 wherein the III-V semiconductor is gallium phosphide and/or gallium arsenide.

16. A process as claimed in any of claims 6 to 15 wherein the film comprises $MP_x$ wherein M represents an alkali metal and x is substantially equal to or greater than 15.

17. A process as claimed in claim 16 wherein the film comprises $KP_{15}$.

FIG. I

# FIG.2

0132322

FIG. 3